Europäisches Patentamt

European Patent Office

Office européen des brevets

(11) Publication number: 0 495 541 A1

# EUROPEAN PATENT APPLICATION

(21) Application number: 92200022.9

(22) Date of filing: 07.01.92

(51) Int. Cl.5: **H01L 29/784**, H01L 21/336,
H01L 29/60, H01L 21/28

(30) Priority: 16.01.91 NL 9100064

(43) Date of publication of application:
22.07.92 Bulletin 92/30

(84) Designated Contracting States:
DE FR GB NL

(71) Applicant: N.V. Philips' Gloeilampenfabrieken
Groenewoudseweg 1
NL-5621 BA Eindhoven(NL)

(72) Inventor: Montree, Andreas Hubertus
c/o INT. OCTROOIBUREAU B.V. Prof.
Holstlaan 6
NL-5656 AA Eindhoven(NL)
Inventor: Woltjer, Reinout
c/o INT. OCTROOIBUREAU B.V. Prof.
Holstlaan 6
NL-5656 AA Eindhoven(NL)
Inventor: Woerlee, Pierre Hermanus
c/o INT. OCTROOIBUREAU B.V. Prof.
Holstlaan 6
NL-5656 AA Eindhoven(NL)

(74) Representative: Jilderda, Anne Ayolt et al
Internationaal Octrooibureau B.V. Prof.
Holstlaan 6
NL-5656 AA Eindhoven(NL)

(54) Method of manufacturing a semiconductor device provided with a field effect transistor.

(57) In a method of manufacturing a semiconductor device provided with a field effect transistor, the transistor is provided with a gate electrode built up of at least two parts, of which a base part has a greater dimension in the direction from the source zone to the drain zone than the superimposed part. To achieve this, a first layer from which the base part is etched is coated with a second layer which is provided with an opening at the area of the gate electrode to be formed. Subsequently, a third layer is provided which fills up the opening. To form the second part of the gate electrode, the third layer is subjected to a material-reducing treatment until a portion thereof remains in the opening.

FIG.1

FIG.2

FIG.3

FIG.4

Rank Xerox (UK) Business Services

The invention relates to a method of manufacturing a semiconductor device provided with a field effect transistor having a source zone and a drain zone and a gate electrode which is built up of at least two parts and of which a base part has a greater dimension in the direction from the source zone to the drain zone than a superimposed second part, a first layer being provided from which the base part of the gate electrode is etched, the first layer being coated with a second layer, an opening being provided in the second layer at the area of the gate electrode to be formed, and the opening being filled with a third layer.

Such a method is known from "The IEEE International Electron Devices Meeting 1989, Technical Digest pp. 769-772". A nucleus layer of polycrystalline silicon is used for the first layer in the method described therein. The nucleus layer is subsequently coated with a silicon oxide layer in which an opening is provided by means of a photomask at the area of the gate electrode to be formed. Then a layer of polycrystalline silicon is provided on the nucleus layer in the opening by selective deposition. The selectively deposited layer forms the second part of the gate electrode. After the oxide layer has been removed and the second part of the gate electrode has been provided with a silicon oxide edge portion on either side, the base part of the gate electrode is etched from the nucleus layer.

In the present state of semiconductor technology, however, selective deposition as used in the known method is a comparatively costly and complicated technique. In addition, this technique does not always allow a material to be used for the second part of the gate electrode which differs much from the material of the nucleus layer from which the base part is formed.

The invention has for its object *inter alia* to provide a method by which a semiconductor device of the kind described above can be manufactured in a simpler way and which is less restricted than the known method as regards the choice of material for the parts of the gate electrode.

According to the invention, the method of the kind described in the opening paragraph is characterized in that the third layer is deposited over the entire assembly and that then the third layer is subjected to a bulk-reducing treatment until a portion thereof remains in the opening in order to form the second part of the gate electrode. Since no selective deposition is used for forming the second part of the gate electrode, according to the invention, the material of the second part need not be matched to that of the base part, which acts as the growing nucleus in the known method.

A particular embodiment of the method according to the invention is characterized in that the third layer is provided over the entire assembly and that then the third layer is subjected to a bulk-reducing treatment until the portion thereof remains in the opening. By means of the comparatively viscous photoresist layer, unevennesses in the surface of the third layer can be smoothed out in this way, so that the second part of the gate electrode will eventually have a flatter surface.

The invention will now be explained in more detail with reference to the drawing, in which

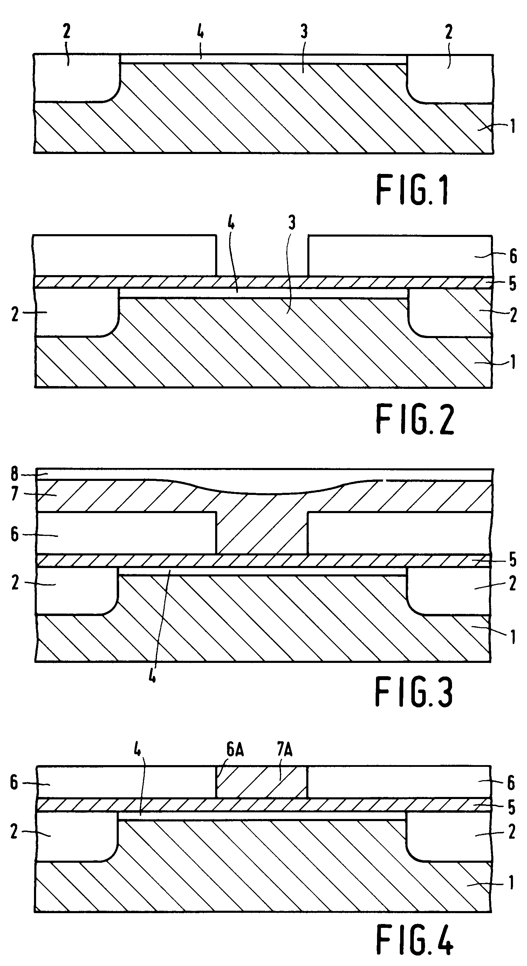

Figs. 1 to 8 show subsequent stages of an embodiment of the method according to the invention in cross-section.

The Figures are purely diagrammatical and not drawn to scale. Some dimensions are particularly strongly exaggerated for the sake of clarity. Corresponding parts in the Figures are indicated with the same reference numerals as much as possible, and semiconductor parts of the same conductivity type are hatched in the same direction.

The method starts with a semiconductor body of silicon, see Fig. 1, with a p-type region 1 adjoining the surface. Field oxide regions 2 which are at least partly countersunk are formed in the semiconductor body through local oxidation in usual manner, thus laterally bounding an island-shaped portion 3 of the p-type region. In the island-shaped portion, an approximately 12.5 nm thick silicon oxide layer 4 is provided on the surface by thermal oxidation, from which layer a gate dielectric of the transistor will be formed.

Subsequently, the entire surface is coated with an n-type amorphous silicon layer 5 with a thickness of approximately 40 nm, see Fig. 2, by means of gas phase deposition (CVD). On the silicon layer 5 is provided an approximately 400 nm thick silicon oxide layer in which an opening 6A is etched in usual manner at the area of the gate electrode to be formed.

The entire assembly is now coated with a comparatively thick, n-type polycrystalline silicon layer 7 which entirely fills the opening 6A, see Fig. 3. The silicon layer 7 may already be doped *in situ* with a suitable n-type dopant, such as phosphorus, during deposition, but doping may also take place after the layer has been provided, for example, by means of implantation or diffusion from $POCl_3$. Small unevennesses in the surface of the polycrystalline silicon layer 7 are smoothed out with a comparatively viscous photoresist layer 8 which is applied by spinning and then cured.

In a plasma containing fluorine, for example, $CF_4/CHF_3/O_2/Ar$, the photoresist layer 8 and the polycrystalline silicon layer are then etched back until the level of the oxide layer 6 is reached. A portion 7A of the silicon layer 7 forming the second part of the gate electrode, see Fig. 4, then remains in the opening 6A.

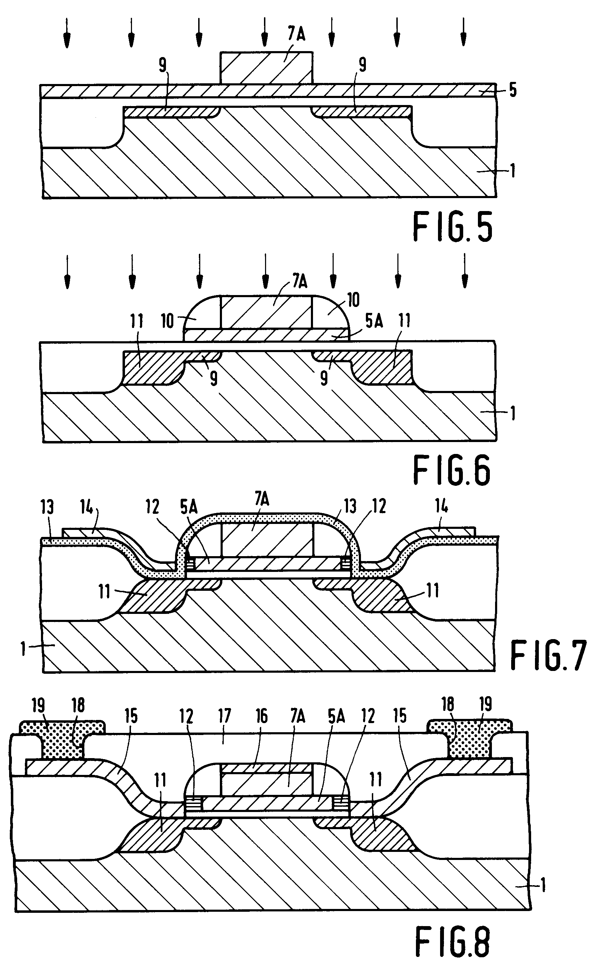

The silicon oxide layer 6 is removed, after which an implantation with arsenic is carried out. The second part of the gate electrode 7A acts as a mask against this implantation, comparatively weakly doped parts 9 of the source and drain zones of the transistor being formed in the p-type semiconductor region 1, see Fig. 5.

Then the entire assembly is coated with a comparatively thick silicon oxide layer by gas phase deposition, upon which the assembly is subjected to an etching treatment in a plasma of $CF_4/CHF_3/Ar$. The deposited oxide layer is etched anisotropically during this. The etching treatment is continued until the amorphous silicon layer 5 is reached. At that moment edge portions 10 of the deposited oxide layer still remain, situated alongside the second part 7A of the gate electrode, see Fig. 6.

The exposed part of the amorphous silicon layer 3 is now etched away with the edge portions 10 and the second part of the gate electrode acting as a mask. The remaining part 5A forms the base part of the gate electrode. As is shown in the Figure, the base part 5A of the gate electrode has a greater dimension in the direction from the source zone to the drain zone than the superimposed part 7A.

A phosphorus implantation is now carried out with the gate electrode structure 5A, 7A, 10 as a mask, in which a considerably higher dose is used than in the previously performed arsenic implantation. The dose during the arsenic implantation, when zones 9 were formed, was approximately $2.10^{13}$ cm$^{-2}$, whereas now the dose is approximately $2.10^{15}$ cm$^{-2}$. Comparatively strongly doped parts 11 of the source and drain zones of the transistor are thereby formed in the p-type region 1, see Fig. 6.

Subsequently, the base layer 5A is partly etched away laterally, after which the resulting cavity is filled with a silicon nitride part 12, see Fig. 7. The cavity may be filled up, for example, in that the entire assembly is coated with a silicon nitride layer of a suitable thickness, which fills the cavity, and in that then the nitride layer is anisotropically etched back, the nitride part 12 remaining intact. The entire surface is now thoroughly cleaned, during which the source and drain zones 11 are exposed, and provided with a titanium layer 13. Then a layer of amorphous silicon is provided, from which strips 14 are formed by masking and etching at the area of the connection electrodes to be formed. The titanium layer 13 is now selectively silicided, the layer being converted to titanium silicide in those areas where the layer 13 is in contact with silicon. Thus connection electrodes 15 are formed on the source and drain zones and the gate electrode is provided with a well conducting top layer 16 of titanium silicide, see Fig. 8. The nitride parts 12 thereby safeguard a good electrical insulation between the connection electrode 15 and the base part 5A of the gate electrode.

After the superfluous parts of the titanium layer have been removed, the assembly is coated with a comparatively thick glass layer 17 which is doped with phosphorus and possibly with boron. Contact windows 18 are etched in usual manner in the glass layer 17 at the areas of the connection electrodes 15, after which an aluminium wiring 19 is provided which contacts the connection electrodes 15 of the source and drain zones 11. The structure thus obtained is depicted in Fig. 8.

Although the invention has been described with reference to only a single embodiment, it will be obvious that the invention is not limited to the embodiment given. Many variations are possible to those skilled in the art within the scope of the invention.

Thus, the term "bulk-reducing treatment" should be given a wide interpretation within the scope of the invention, so that it includes further treatments by which the thickness of the treated layer is gradually reduced. Thus the treatments may be carried out not only by (chemical) etching, but also, for example, by (mechanical) polishing, or a combination of the two.

Furthermore, the conductivity types mentioned are given by way of example only. The conductivity types given may be replaced by their opposites within the scope of the invention. In particular, the invention is also applicable to the formation of a p-channel field effect transistor (PMOS), possibly in combination with an n-channel transistor in the same semiconductor body (CMOS).

## Claims

1. A method of manufacturing a semiconductor device provided with a field effect transistor having a source zone and a drain zone and a gate electrode which is built up of at least two parts and of which a base part has a greater dimension in the direction from the source zone to the drain zone than a superimposed second part, a first layer being provided from which the base part of the gate electrode is etched, the first layer being coated with a second layer, an opening being provided in the second layer at the area of the gate electrode to be formed, and the opening being filled with a third layer, characterized in that the third layer is deposited over the entire assembly and that then the third layer is subjected to a bulk-reducing treatment until a portion thereof remains in the opening in order to form the second part of the gate electrode.

2. A method as claimed in Claim 1, characterized in that an etching treatment is carried out as the bulk-reducing treatment.

3. A method as claimed in Claim 2, characterized in that, before the third layer is etched back, a photoresist layer is provided which is subsequently also etched back.

4. A method as claimed in Claim 1 or 2, characterized in that a layer of amorphous silicon and a layer of polycrystalline silicon are used as the first and the third layer, respectively.

5. A method as claimed in Claim 1, characterized in that a polishing treatment is carried out as the bulk-reducing treatment.

6. A method as claimed in any one of the preceding Claims, characterized in that a silicon oxide layer is used as the second layer.

7. A method as claimed in any one of the preceding Claims, characterized in that the second layer is removed after the third layer has been etched back.

8. A method as claimed in Claim 7, characterized in that after the removal of the second layer a doping treatment is carried out so as to form a first part of the source and drain zone, in that subsequently an edge portion is formed at least along the second part of the gate electrode, after which the base part of the gate electrode is etched from the first layer, the second part of the gate electrode and the edge portion serving as a mask, and in that then a doping treatment is carried out so as to form a more heavily doped, second part of the source and drain zone.

FIG.1

FIG.2

FIG.3

FIG.4

FIG.5

FIG.6

FIG.7

FIG.8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | US-A-4 984 042 (MOTOROLA, INC.) <br> * the whole document * <br> --- | 1-3,6,7 | H01L29/784 <br> H01L21/336 <br> H01L29/60 |
| Y | US-A-4 895 520 (STANDARD MICROSYSTEMS CORPORATION) <br> * the whole document * <br> --- | 1-3,6,7 | H01L21/28 |
| A | US-A-4 907 048 (XEROX CORPORATION) <br> * column 6, line 15 - line 29; figure 9 * <br> --- | 1 | |
| A | US-A-4 677 736 (GENERAL ELECTRIC COMPANY) <br> * column 4, line 40 - column 5, line 11; figures 9-11 * <br> --- | 1 | |
| A | EP-A-0 402 784 (KAKUSHIKI KAISHA TOSHIBA) <br> * abstract * <br> ----- | 4 | |

**TECHNICAL FIELDS SEARCHED (Int. Cl.5)**

H01L

The present search report has been drawn up for all claims

| Place of search | Date of completion of the search | Examiner |
|---|---|---|
| THE HAGUE | 02 APRIL 1992 | MIMOUN B.J. |